# DEMANDE DE BREVET EUROPEEN

(11) **EP 2 772 941 A1**
(43) Date de publication de la demande: **03.09.2014**
(21) Numéro de dépôt: 14157272.7
(22) Date de dépôt: 28.02.2014
(51) Int. Cl.: H01L 29/66, H01L 29/78

(54) **Procédé de fabrication d'un transistor MOS à ailette**

(30) Priorité: 01.03.2013 FR 1351827
(71) Demandeur: STmicroelectronics SA, 92120 Montrouge (FR); COMMISSARIAT A L'ENERGIE ATOMIQUE ET AUX ENERGIES ALTERNATIVES, 75015 Paris (FR)
(72) Inventeur: Morand, Yves, 38000 GRENOBLE (FR); Wacquez, Romain, 13008 MARSEILLE (FR); Grenouillet, Laurent, ALBANY, NY New York 12203 (US); Le Tiec, Yannick, 38920 CROLLES (FR); Vinet, Maud, 44690 La Haye Fouassiere (FR)
(74) Mandataire: Thibon, Laurent

(57) **Abrégé**

L'invention concerne un procédé de fabrication d'un transistor MOS à ailette à partir d'une structure de type SOI comportant une couche semiconductrice (101) sur une couche d'oxyde de silicium (103) revêtant un support semiconducteur (105), ce procédé comprenant les étapes suivantes : a) former, depuis la surface de la couche semiconductrice (101), au moins une tranchée délimitant au moins une ailette (107) dans la couche semiconductrice (101) et s'étendant jusqu'à la surface du support semiconducteur (105) ; b) graver les flancs d'une partie de la couche d'oxyde de silicium (103) située sous l'ailette (107) de façon à former au moins un renfoncement sous l'ailette ; et c) remplir le renfoncement d'un matériau (209) gravable sélectivement par rapport à l'oxyde de silicium.

## Description

### Domaine

La présente demande concerne des techniques de fabrication de composants semiconducteurs. Elle vise plus particulièrement un procédé de fabrication d'un transistor MOS, et un transistor pouvant être obtenu par ce procédé.

### Exposé de l'art antérieur

On connaît des transistors MOS dont une partie active comprend une ailette semiconductrice reposant sur un support, une grille conductrice isolée située sur deux ou trois côtés de l'ailette permettant, selon son état de polarisation, de mettre le transistor dans un état passant ou bloqué. De tels transistors sont parfois désignés dans la technique par le terme finFET (de l'anglais "fin field effect transistor" - transistor à effet de champ à ailette). Dans la présente description, les transistors de ce type sont appelés transistors à ailette.

On a notamment proposé de réaliser un transistor MOS à ailette à partir d'une structure de type SOI (de l'anglais "semiconductor on insulator" - semiconducteur sur isolant) comportant une couche semiconductrice sur une couche d'oxyde de silicium revêtant un support semiconducteur. L'ailette est alors formée dans la couche semiconductrice de la structure SOI.

Dans la pratique, la fabrication de transistors MOS à ailette sur structure SOI pose toutefois des problèmes techniques.

### Résumé

Ainsi, un mode de réalisation prévoit un procédé de fabrication d'un transistor MOS à ailette à partir d'une structure de type SOI comportant une couche semiconductrice sur une couche d'oxyde de silicium revêtant un support semiconducteur, ce procédé comprenant les étapes suivantes : a) former, depuis la surface de la couche semiconductrice, au moins une tranchée délimitant au moins une ailette dans la couche semiconductrice et s'étendant jusqu'à la surface du support semiconducteur ; b) graver les flancs d'une partie de la couche d'oxyde de silicium située sous l'ailette de façon à former au moins un renfoncement sous l'ailette ; et c) remplir le renfoncement d'un matériau gravable sélectivement par rapport à l'oxyde de silicium.

Selon un mode de réalisation, le matériau a une constante diélectrique supérieure à celle de l'oxyde de silicium.

Selon un mode de réalisation, le matériau est un nitrure.

Selon un mode de réalisation, le procédé comporte en outre l'étape de prolonger la tranchée jusqu'à un niveau intermédiaire du support.

Selon un mode de réalisation, le procédé comporte en outre l'étape de revêtir d'une couche de nitrure les flancs, accessibles depuis la tranchée, de la portion de support située sous l'ailette.

Selon un mode de réalisation, le procédé comporte en outre, avant l'étape de revêtement, une étape de formation, depuis la tranchée, d'un renfoncement dans la portion de support située sous l'ailette.

Selon un mode de réalisation, le procédé comporte en outre, avant l'étape de revêtement, une étape de dépôt d'une couche d'oxyde de silicium sur les flancs.

Selon un mode de réalisation, le procédé comporte en outre l'étape de remplir la tranchée d'oxyde de silicium.

Selon un mode de réalisation, le procédé comporte en outre une étape au cours de laquelle les flancs et la face supérieure de l'ailette sont mis à nu.

Selon un mode de réalisation, le procédé comporte en outre l'étape de former un empilement de grille revêtant les flancs et la face supérieure de l'ailette.

Un autre mode de réalisation prévoit un transistor MOS réalisé à partir d'une structure de type SOI comportant une couche semiconductrice sur une couche d'oxyde de silicium revêtant un support semiconducteur, ce transistor comprenant : au moins une ailette délimitée par au moins une tranchée formée depuis la surface de la couche semiconductrice ; et au moins une région en un matériau gravable sélectivement par rapport à l'oxyde de silicium, située dans un renfoncement formé dans une partie de la couche d'oxyde de silicium située sous l'ailette.

Un autre mode de réalisation prévoit un transistor MOS disposé dans et/ou sur un support semiconducteur, comprenant : au moins une ailette semiconductrice disposée sur le support et séparée du support par une portion d'une couche d'oxyde de silicium ; et au moins une région en un matériau gravable sélectivement par rapport à l'oxyde de silicium, située dans un renfoncement situé sous l'ailette, entre l'ailette, le support et la portion de couche d'oxyde de silicium.

Selon un mode de réalisation, le transistor comprend une électrode de contrôle reliée à une portion du support située sous l'ailette.

### Brève description des dessins

Ces caractéristiques et leurs avantages, ainsi que d'autres, seront exposés en détail dans la description suivante de modes de réalisation particuliers faite à titre non limitatif en relation avec les figures jointes parmi lesquelles :
la figure 1 est une vue en perspective représentant de façon schématique un exemple d'un transistor MOS à ailette ;
les figures 2A à 2J sont des vues en coupe illustrant de façon schématique des étapes d'un mode de réalisation d'un procédé de fabrication d'un transistor MOS à ailette ; et
les figures 3A à 3E sont des vues en coupe illustrant de façon schématique des étapes d'une variante de réalisation du procédé des figures 2A à 2J.

Par souci de clarté, de mêmes éléments ont été désignés par de mêmes références aux différentes figures et, de plus, comme cela est habituel dans la représentation des circuits intégrés, les diverses figures ne sont pas tracées à l'échelle.

### Description détaillée

Les transistors décrits ci-après sont formés à partir d'une structure de type SOI comportant une couche semiconductrice 101 sur une couche d'oxyde de silicium 103 revêtant un support semiconducteur 105. Dans la suite de la présente description, on définit les termes "dessus", "dessous", "haut", "bas", "supérieur" et "inférieur" par rapport à un axe vertical lorsque la structure SOI est positionnée de façon que la face du support semiconducteur 105 opposée à la couche d'oxyde de silicium 103 soit dans un plan approximativement horizontal et soit tournée vers le bas, comme cela est représenté sur les figures.

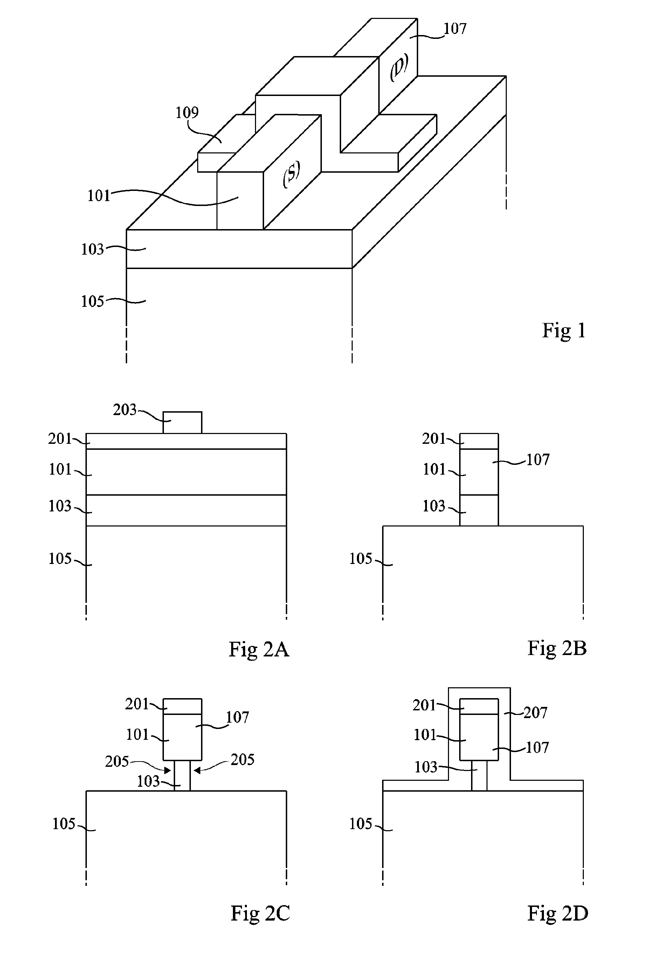

La figure 1 est une vue en perspective représentant de façon schématique un exemple d'un transistor MOS à ailette réalisé à partir d'une structure SOI. Des tranchées gravées depuis la face supérieure de la couche 101 et s'étendant en profondeur jusqu'à la face supérieure de la couche d'oxyde de silicium 103 délimitent une ailette semiconductrice 107 formée dans la couche 101. La face inférieure de l'ailette 107 repose sur la couche d'oxyde de silicium 103. Un empilement de grille 109, comportant par exemple une couche diélectrique revêtue d'une couche conductrice (non différenciées sur les figures), est formé sur les trois faces libres d'au moins un tronçon de l'ailette, à savoir ses faces latérales et sa face supérieure. Le tronçon d'ailette 107 partiellement entouré par la grille 109 constitue une région de formation de canal du transistor. De part et d'autre de la grille 109, on trouve des portions de la couche 101 constituant respectivement une région de source (S) et une région de drain (D) du transistor.

Dans un transistor à ailette du type décrit en relation avec la figure 1, le plus grand nombre de côtés sur lesquels la grille 109 contrôle le canal du transistor permet un meilleur contrôle du transistor par rapport aux transistors MOS planaires. Ceci permet de réaliser des transistors de plus petites dimensions que les transistors MOS planaires, ou, à dimensions critiques identiques, de réaliser des transistors ayant des effets de canaux courts moins importants et pouvant supporter, à l'état passant, des courants plus élevés que les transistors MOS planaires.

Un avantage des transistors à ailette réalisés sur structure SOI est que leurs propriétés électriques (par exemple leur tension de seuil) peuvent, du fait du couplage qui existe entre le support semiconducteur 105 et la partie active du transistor, être modulées par la tension appliquée au support semiconducteur 105. Pour profiter au mieux du couplage avec le support 105, il convient toutefois que l'épaisseur de la couche d'oxyde de silicium 103 soit faible, par exemple inférieure à 25 nm et de préférence inférieure à 15 nm, ce qui peut entraîner des difficultés techniques lors de la fabrication du transistor.

Lors de la fabrication du transistor de la figure 1, plusieurs étapes successives de gravure et de nettoyage peuvent être prévues, notamment pour former l'ailette 107 dans la couche 101, puis, ultérieurement, pour délimiter l'empilement de grille 109.

Pour améliorer ce dispositif, on cherche à éviter que ces gravures et nettoyages entraînent une consommation non souhaitée de la couche d'oxyde de silicium 103 au niveau des surfaces gravées. Lorsque la couche 103 de la structure SOI de départ est très mince, des courts-circuits peuvent se produire entre la partie active du transistor et le support 105, rendant le transistor inutilisable.

Indépendamment de l'épaisseur de la couche 103 et des phénomènes de court-circuit entre la partie active et le support 105, les gravures et nettoyages qui précédent le dépôt de l'empilement de grille 109 peuvent entraîner une consommation de la couche 103 sous les bords de l'ailette 107, créant ainsi une cavité ou un renfoncement sous la périphérie de l'ailette. Cette cavité peut être remplie au moins en partie par l'empilement de grille 109. Ceci pose un problème de définition de la largeur de conduction du transistor. En effet, la consommation de la couche 103 sous l'ailette 107 est relativement mal contrôlée et peut induire une variabilité de la largeur de conduction d'un transistor à un autre, ce qui n'est pas souhaitable.

Un objet des modes de réalisation décrits est d'améliorer le dispositif de la figure 1.

Les figures 2A à 2J sont des vues en coupe illustrant de façon schématique des étapes d'un exemple d'un procédé de fabrication d'un transistor MOS à ailette à partir d'une structure SOI.

La figure 2A illustre la structure SOI de départ. La couche semiconductrice 101 est par exemple en silicium ou en silicium-germanium, et le support 105 est par exemple en silicium. D'autres matériaux semiconducteurs peuvent être utilisés pour former la couche 101 et le support 105. A titre d'exemple, la couche d'oxyde de silicium 103 a une épaisseur relativement mince, par exemple comprise entre 5 et 15 nm, et la couche semiconductrice 101 a une épaisseur comprise entre 10 et 25 nm. Une couche de nitrure de silicium 201 est déposée sur la couche semiconductrice 101. Une mince couche d'interface non représentée, par exemple en oxyde de silicium, peut être prévue entre la couche 101 et la couche 201. Un masque de gravure 203, par exemple en résine, est formé sur la couche de nitrure 201. Le masque 203 a, vu de dessus, la forme de la partie semiconductrice active du transistor que l'on souhaite réaliser, et, en particulier, une partie du masque 203 a, vue de dessus, la forme d'une ailette que l'on souhaite former dans la couche semiconductrice 101.

La figure 2B illustre une étape postérieure à la formation du masque 203, au cours de laquelle les parties des couches 201, 101 et 103 non protégées par le masque 203 sont retirées par gravure depuis la face supérieure de la structure, ce qui revient à former une tranchée délimitant, dans la couche 101, la partie active du transistor et en particulier une ailette semiconductrice 107. La tranchée délimitant la partie active du transistor s'étend en profondeur jusqu'à la face supérieure du support semiconducteur 105 dans cet exemple. L'ailette 107 a par exemple une largeur comprise entre 10 et 30 nm.

La figure 2C illustre une étape postérieure à l'étape de gravure des couches 201, 101 et 103, au cours de laquelle la portion de la couche d'oxyde de silicium 103 située sous la partie active du transistor, et en particulier sous l'ailette 107, est gravée latéralement depuis ses flancs. Un renfoncement 205 de même épaisseur que la couche d'oxyde 103 est ainsi créé sous une région périphérique de la partie active du transistor. On notera que lors de l'étape de gravure latérale de la figure 2C, seule une partie de la couche d'oxyde de silicium située sous l'ailette 107 est retirée, une portion de couche 103 située sous la partie centrale de l'ailette 107 étant conservée.

La figure 2D illustre une étape postérieure à la formation du renfoncement 205, au cours de laquelle on réalise un dépôt conforme d'une couche 207 d'un matériau susceptible d'être gravé de façon sélective par rapport à l'oxyde de silicium. Plus particulièrement, selon un premier aspect, on choisit, pour former la couche 207, un matériau résistant mieux que l'oxyde de silicium aux diverses étapes de gravure et de nettoyage prévues dans la fabrication d'un transistor MOS à ailette. Selon un autre aspect, la couche 207 est de préférence en un matériau ayant une constante diélectrique supérieure à celle de l'oxyde de silicium. La couche 207 est de préférence en nitrure, par exemple en nitrure de silicium ou en nitrure de bore. D'autres matériaux ayant à la fois une constante diélectrique supérieure à celle de l'oxyde de silicium et une bonne résistance aux nettoyages peuvent être utilisés, par exemple de l'oxyde d'hafnium ou de l'oxyde de zirconium. Comme cela apparaît sur la figure 2D, l'épaisseur de la couche 207 est choisie de façon que la couche 207 comble le renfoncement 205 créé lors de l'étape de gravure latérale de la figure 2C. A titre d'exemple, le renfoncement 205 peut avoir une largeur de l'ordre de 5 nm, et la couche 207 peut avoir une épaisseur du même ordre de grandeur.

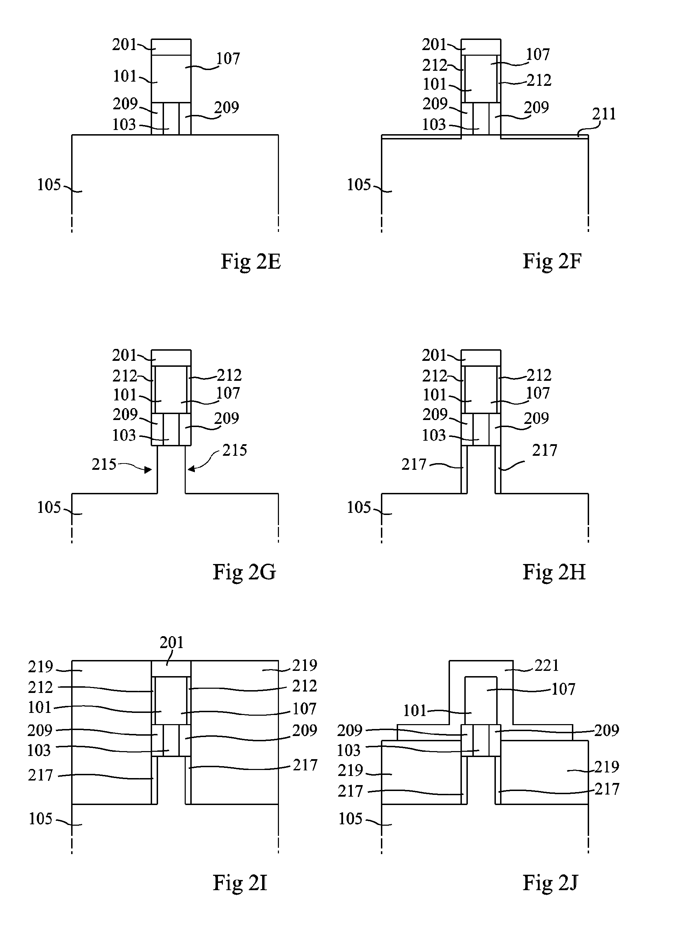

La figure 2E illustre une étape postérieure au dépôt de la couche 207, au cours de laquelle la couche 207 est gravée de façon à ne conserver de cette couche qu'une région 209 située sous la périphérie de la partie active du transistor, et comblant le renfoncement périphérique 205 formé lors de l'étape de gravure de la figure 2C. La région 209 remplace ainsi la portion de couche d'oxyde de silicium 103 gravée sous la partie active du transistor lors de l'étape de gravure de la figure 2C. On notera que le fait de conserver, lors de l'étape de gravure de la figure 2C, une portion de couche 103 sous la partie centrale de l'ailette 107, permet d'éviter un affaissement, même partiel, de l'ailette 107, et de faire en sorte que la région 209 ait exactement la même hauteur que la couche 103. A titre d'exemple, la gravure de la couche 207 peut comprendre une première étape de gravure sèche anisotrope, permettant de retirer l'essentiel de la couche 207 à l'exception de la région 209 et d'une partie de l'épaisseur de la couche 207 revêtant les flancs de l'ailette, suivie d'une deuxième étape de gravure humide, par exemple à base d'acide fluorhydrique et d'éthylène glycol, permettant de bien dégager les flancs de l'ailette 107 d'éventuels résidus de la couche 207. A titre de variante, une unique étape de gravure isotrope peut être mise en oeuvre pour graver la couche 207.

La figure 2F illustre une étape optionnelle d'oxydation des surfaces semiconductrices laissées libres à l'issue de l'étape de gravure de la figure 2E. Lors de cette étape, il se forme une couche d'oxyde 211 sur la surface du support 105 entourant, vu de dessus, la partie active du transistor, et une couche d'oxyde 212 sur les flancs de la partie active du transistor et en particulier sur les flancs de l'ailette 107.

La figure 2G illustre une étape de gravure anisotrope, depuis la face supérieure de la structure, de la couche d'oxyde 211 et d'une portion du support semiconducteur 105 entourant, vu de dessus, la partie active du transistor. Ceci revient à prolonger verticalement, jusqu'à un niveau intermédiaire du support 105, la tranchée formée à l'étape de gravure de la figure 2B, qui délimite la partie active du transistor. A titre d'exemple, 10 à 200 nm d'épaisseur du support 105 peuvent être retirés autour de la partie active du transistor et en particulier autour de l'ailette 107 lors de cette étape. La couche de nitrure 201 recouvrant la partie active du transistor sert de masque dur à la gravure. Après l'étape de gravure anisotrope du support 105, une étape de gravure isotrope du support 105 peut être prévue pour créer un léger renfoncement 215, par exemple de 1 à 5 nm de large, dans la partie du support 105 située sous la région 209. Lors de cette étape de gravure isotrope, la couche d'oxyde 212 protège les flancs de la partie active du transistor.

La figure 2H illustre la formation d'un revêtement de nitrure 217 sur les flancs, rendus accessibles lors des étapes de gravure de la figure 2G, de la partie supérieure du support 105 située sous la région active du transistor. Dans l'exemple représenté, le revêtement 217 comble le renfoncement 215 créé à l'issue de l'étape de gravure isotrope de la figure 2G. A titre d'exemple, pour réaliser le revêtement 217, on peut réaliser un dépôt conforme de nitrure sur toute la surface de la structure, puis réaliser une gravure anisotrope pour retirer la couche de nitrure à l'exception de la portion de cette couche située dans le renfoncement 215.

La figure 2I illustre une étape postérieure à la formation du revêtement de nitrure 217, au cours de laquelle la cavité ou tranchée entourant la partie active du transistor et en particulier l'ailette 107 est entièrement remplie d'oxyde de silicium 219. A titre d'exemple, pour réaliser ce remplissage, de l'oxyde de silicium est déposé sur toute la structure jusqu'à une hauteur supérieure à celle de la couche de nitrure 201, puis une étape de planarisation mécano-chimique s'arrêtant sur la couche de nitrure 201 est mise en oeuvre pour retirer l'excès d'oxyde de silicium.

Lors d'une étape non représentée, postérieure à la formation de la région d'oxyde de silicium 219, la couche de nitrure 201 est retirée, par exemple par gravure à base d'acide orthophosphorique chaud.

Après le retrait de la couche de nitrure 201, une partie supérieure de la région d'oxyde de silicium 219 entourant la partie active du transistor, ainsi que la couche d'oxyde 212 revêtant les flancs de la partie active du transistor, sont retirées par gravure de façon à libérer entièrement les flancs de la partie active du transistor, et en particulier de l'ailette 107. A titre d'exemple, la gravure de l'oxyde de silicium 219 est arrêtée à un niveau intermédiaire entre la face supérieure et la face inférieure de la région 209 (et donc de la couche d'oxyde de silicium 103 sur laquelle la région 209 est verticalement alignée).

La figure 2J illustre une étape postérieure à la gravure des régions d'oxyde 212 et 219, au cours de laquelle un empilement de grille 221 revêtant la face supérieure et les flancs de l'ailette 107 est réalisé.

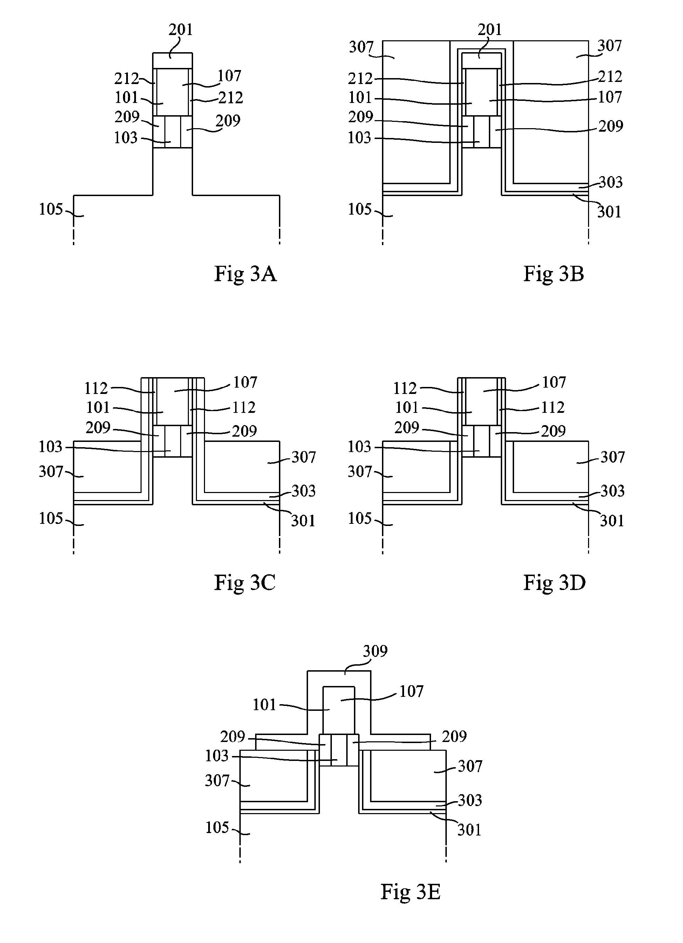

Les figures 3A à 3E sont des vues en coupe illustrant de façon schématique des étapes d'un exemple d'une variante de réalisation du procédé de fabrication d'un transistor à ailette décrit en relation avec les figures 2A à 2J.

Les étapes initiales du procédé des figures 3A à 3E sont identiques ou similaires à celles du procédé des figures 2A à 2J. En particulier, dans cet exemple, les étapes des figures 2A à 2F sont communes aux deux procédés et n'ont donc pas été représentées sur les figures 3A à 3E.

La figure 3A illustre une étape postérieure à l'étape d'oxydation de la figure 2F, au cours de laquelle une gravure anisotrope de la couche d'oxyde 211 et d'une partie supérieure du support semiconducteur 105 est réalisée. Cette gravure anisotrope est identique ou similaire à l'étape de gravure anisotrope de la figure 2G. Une différence avec le procédé des figures 2A à 2J est que le procédé des figures 3A à 3E ne comprend pas l'étape de gravure isotrope de la figure 2G, formant un renfoncement périphérique 215 (figure 2G) dans le support 105 sous la partie active du transistor.

La figure 3B illustre une étape postérieure à l'étape de gravure anisotrope de la figure 3A, au cours de laquelle on réalise un premier dépôt conforme d'une couche d'oxyde de silicium 301, par exemple de 2 à 5 nm d'épaisseur, suivi d'un deuxième dépôt conforme d'une couche de nitrure 303, par exemple de 3 à 10 nm d'épaisseur. Après le dépôt de la couche 303, la cavité ou tranchée entourant la partie active du transistor est entièrement remplie d'oxyde de silicium 307. A titre d'exemple, pour réaliser ce remplissage, de l'oxyde de silicium est déposé sur toute la structure jusqu'à une hauteur supérieure à celle de la partie haute de la couche de nitrure 303 surmontant la face supérieure de la couche 201, puis une étape de planarisation mécano-chimique, s'arrêtant sur la partie haute de la couche de nitrure 303 surmontant la face supérieure de la couche 201, est mise en oeuvre pour retirer l'excès d'oxyde de silicium.

Lors d'une étape non représentée, postérieure à la formation de la région d'oxyde de silicium 307, les parties hautes des couches d'oxyde 301 et de nitrure 303 surmontant la couche de nitrure 201, ainsi que la couche de nitrure 201, sont retirées, par exemple par gravure à base d'acide fluorhydrique, d'éthylène glycol et d'acide phosphorique.

La figure 3C illustre une étape postérieure au retrait de la couche de nitrure 201, au cours de laquelle une partie supérieure de la région d'oxyde de silicium 307 entourant la partie active du transistor est retirée par gravure, jusqu'à un niveau inférieur à la face inférieure de la couche semiconductrice 101, par exemple jusqu'à un niveau intermédiaire entre la face supérieure et la face inférieure de la région 209.

La figure 3D illustre une étape postérieure à l'étape de gravure de la figure 3C, au cours de laquelle la portion de la couche de nitrure 303 située sur les flancs de la partie active du transistor est retirée, par exemple par gravure à base d'acide phosphorique.

Lors d'une étape non représentée, postérieure à l'étape de gravure de la figure 3D, la portion de la couche d'oxyde 301 située sur les flancs de la partie active du transistor, ainsi que la couche d'oxyde 212, sont retirées par gravure, de façon à libérer entièrement les flancs de la partie active du transistor et en particulier de l'ailette 107.

La figure 3E illustre une étape postérieure au retrait de la couche d'oxyde 212, au cours de laquelle un empilement de grille 309 revêtant la face supérieure et les flancs de l'ailette 107 est réalisé.

Un avantage des modes de réalisation décrits en relation avec les figures 2A à 2J et 3A à 3E est qu'ils permettent d'éviter tout risque de court-circuit avec le support semiconducteur 105, et ce même lorsque la couche d'oxyde de silicium 103 de la structure SOI de départ est très mince, par exemple inférieure à 25 nm d'épaisseur. En effet, sous la partie active du transistor, la région 209 en un matériau résistant aux diverses étapes de gravure et de nettoyage prévient tout risque de court-circuit avec le support 105, et, autour de la partie active du transistor, la tranchée remplie d'oxyde 219 ou 307 prévient les risques de court-circuit avec le support 105. Le revêtement de nitrure 217 (dans le mode de réalisation des figures 2A à 2J) et la couche de nitrure 303 (dans le mode de réalisation des figures 3A à 3E) renforcent encore la protection contre les risques de court-circuit avec le support 105 autour des flancs de la partie active du transistor.

Un autre avantage des modes de réalisation décrits en relation avec les figures 2A à 2J et 3A à 3E est qu'ils permettent, grâce aux régions 209, d'éviter des problèmes de variabilité de la largeur de conduction du transistor liés à la consommation de la couche 103 sous la partie active du transistor, et en particulier sous l'ailette 107. En effet, la région 209 étant en un matériau résistant aux diverses solutions de gravure et de nettoyage utilisées lors de la fabrication du transistor, aucune consommation indésirable de la région 209 sous les bords de l'ailette ne se produit.

Un autre avantage des modes de réalisation décrits en relation avec les figures 2A à 2J et 3A à 3E est que pour une épaisseur donnée de la couche d'oxyde de silicium 103 de la structure SOI de départ, ils permettent, dans le cas où la région 209 est en un matériau à plus forte constante diélectrique que l'oxyde de silicium, d'améliorer le couplage avec le support 105 par rapport à un transistor du type décrit en relation avec la figure 1.

Dans le cas où la couche semiconductrice supérieure de la structure SOI de départ est une couche de silicium-germanium, il peut être avantageux, après avoir libéré les faces supérieure et latérales de l'ailette 107 et avant le dépôt de l'empilement de grille, de mettre en oeuvre une étape de condensation du germanium par oxydation thermique, de façon à obtenir une concentration en germanium plus importante sur les trois facettes de l'ailette destinées à être en contact avec la grille.

Des modes de réalisation particuliers ont été décrits. Diverses variantes et modifications apparaîtront à l'homme de l'art.

En particulier, les modes de réalisation décrits ne se limitent pas aux exemples numériques d'épaisseur mentionnés dans la présente description.

De plus, bien que les modes de réalisation décrits soient particulièrement avantageux pour réaliser des transistors MOS à ailette à partir de structures SOI dans lesquelles la couche enterrée d'oxyde de silicium est très mince, ils ne se limitent pas à ce cas particulier et sont aussi compatibles avec des structures SOI dans lesquelles la couche d'oxyde de silicium est épaisse, par exemple d'épaisseur allant de plusieurs dizaines à plusieurs centaines de nanomètres.

Par ailleurs, par souci de simplification, on a représenté sur les figures des transistors MOS comportant une unique ailette entre une région de source et une région de drain. Les modes de réalisation décrits ne se limitent pas à ce cas particulier et sont compatibles avec des transistors comportant plusieurs ailettes parallèles entre une région de source et une région de drain.

En outre, dans les exemples représentés sur les figures, l'empilement de grille permet de contrôler trois faces de l'ailette du transistor. Les modes de réalisation décrits ne se limitent pas à ce cas particulier. A titre de variante, on peut réaliser un transistor à ailette dans lequel seules les faces latérales de l'ailette sont contrôlées par la grille. Pour cela, on peut par exemple prévoir d'intercaler une épaisseur isolante supplémentaire entre la face supérieure de l'ailette et l'empilement de grille, de façon à désactiver le contrôle de la face supérieure de l'ailette par la grille.

De plus, bien que cela n'ait pas été représenté sur les figures, une étape supplémentaire d'implantation d'éléments dopants dans la région du support 105 située sous l'ailette 107 peut optionnellement être prévue, de façon à augmenter le couplage entre le substrat et la partie active du transistor. Cette étape d'implantation est de préférence réalisée après le dépôt de la couche 207 (figure 2D), en utilisant tout ou partie de la couche 207 pour éviter que des éléments dopants ne soient implantés dans la région de canal du transistor.

Que l'on prévoit ou non une étape d'implantation d'éléments dopants dans la région du support 105 située sous l'ailette 107, une électrode de contrôle, non représentée sur les figures, peut être reliée à la région du support 105 située sous l'ailette 107.

A titre d'exemple, l'implantation d'éléments dopants dans la région de support 105 située sous l'ailette 107 peut être réalisée depuis la face supérieure de la structure, juste après le dépôt de la couche 207, avec une orientation d'implantation sensiblement verticale. L'énergie d'implantation est de préférence choisie suffisamment élevée pour traverser la couche 207 dans le sens de l'épaisseur, et suffisamment basse pour ne pas traverser le capot supérieur de nitrure 201. La région de canal du transistor est alors protégée de l'implantation par le capot de nitrure supérieur 201 d'une part, et par la partie de la couche 207 recouvrant les flancs de l'ailette 107 d'autre part. Un recuit (par exemple à une température de l'ordre de 1050°C pendant environ 5 secondes) peut optionnellement être prévu pour favoriser la diffusion des éléments dopants sous toute la surface de la région de canal du transistor.

A titre de variante, l'implantation peut être réalisée avec un léger angle par rapport à la verticale, ce qui permet une meilleure pénétration des éléments dopants sous toute la surface de la région de canal du transistor. L'angle d'implantation est toutefois de préférence choisi suffisamment proche de la verticale pour éviter autant que possible l'implantation d'éléments dopants dans la région de canal du transistor au niveau des flancs de l'ailette 107.

A titre de variante, lorsque l'étape de gravure de la couche 207 de la figure 2E comprend une première étape de gravure anisotrope pour retirer l'essentiel de la couche 207 à l'exception de la région 209 et de la partie de couche 207 revêtant les flancs de l'ailette 107, suivie d'une deuxième étape de gravure isotrope pour retirer la partie de la couche 207 située sur les flancs de l'ailette, on peut prévoir de réaliser l'implantation du support 105 entre ces deux étapes de gravure. L'énergie d'implantation peut alors être réduite par rapport aux variantes susmentionnées, puisque la face supérieure du support 105 autour de l'ailette 107 n'est plus revêtue par la couche 207. La région de canal du transistor reste protégée de l'implantation par le capot de nitrure 201 et par une partie de la couche 207 recouvrant les flancs de l'ailette.

## Revendications

1. Procédé de fabrication d'un transistor MOS à ailette à partir d'une structure de type SOI comportant une couche semiconductrice (101) sur une couche d'oxyde de silicium (103) revêtant un support semiconducteur (105), ce procédé comprenant les étapes suivantes :
a) former, depuis la surface de la couche semiconductrice (101), au moins une tranchée délimitant au moins une ailette (107) dans la couche semiconductrice (101) et s'étendant jusqu'à la surface du support semiconducteur (105) ;
b) graver les flancs d'une partie de la couche d'oxyde de silicium (103) située sous l'ailette (107) de façon à former au moins un renfoncement (205) sous l'ailette ; et
c) remplir ledit au moins un renfoncement (205) d'un matériau (207, 209) gravable sélectivement par rapport à l'oxyde de silicium.

2. Procédé selon la revendication 1, dans lequel ledit matériau (207, 209) a une constante diélectrique supérieure à celle de l'oxyde de silicium.

3. Procédé selon la revendication 1 ou 2, dans lequel ledit matériau (207, 209) est un nitrure.

4. Procédé selon l'une quelconque des revendications 1 à 3, comportant en outre l'étape de prolonger ladite au moins une tranchée jusqu'à un niveau intermédiaire du support (105).

5. Procédé selon la revendication 4, comportant en outre l'étape de revêtir d'une couche de nitrure (217 ; 303) les flancs, accessibles depuis ladite au moins une tranchée, de la portion de support (105) située sous l'ailette (107).

6. Procédé selon la revendication 5, comportant en outre, avant ladite étape de revêtement, une étape de formation, depuis ladite au moins une tranchée, d'un renfoncement (215) dans la portion de support (105) située sous l'ailette (107).

7. Procédé selon la revendication 5, comportant en outre, avant ladite étape de revêtement, une étape de dépôt d'une couche d'oxyde de silicium (301) sur lesdits flancs.

8. Procédé selon l'une quelconque des revendications 4 à 7, comportant en outre l'étape de remplir ladite au moins une tranchée d'oxyde de silicium (219 ; 307).

9. Procédé selon l'une quelconque des revendications 1 à 8, comportant en outre une étape au cours de laquelle les flancs et la face supérieure de l'ailette (107) sont mis à nu.

10. Procédé selon l'une quelconque des revendications 1 à 9, comportant en outre l'étape de former un empilement de grille (221 ; 309) revêtant les flancs et la face supérieure de l'ailette (107).

11. Transistor MOS réalisé à partir d'une structure de type SOI comportant une couche semiconductrice (101) sur une couche d'oxyde de silicium (103) revêtant un support semiconducteur (105), ce transistor comprenant :
au moins une ailette (107) délimitée par au moins une tranchée formée depuis la surface de la couche semiconductrice (101) ; et
au moins une région (209) en un matériau gravable sélectivement par rapport à l'oxyde de silicium, située dans un renfoncement de même hauteur que la couche d'oxyde (103) formé dans une partie de la couche d'oxyde de silicium (103) située sous l'ailette.

12. Transistor MOS disposé dans et/ou sur un support semiconducteur (105), comprenant :
au moins une ailette semiconductrice (107) disposée sur le support (105) et séparée du support (105) par une portion d'une couche d'oxyde de silicium (103) ; et
au moins une région (209) en un matériau diélectrique gravable sélectivement par rapport à l'oxyde de silicium, située dans un renfoncement de même hauteur que la couche d'oxyde (103) situé sous l'ailette (107), entre l'ailette (107), le support (105) et la portion de couche d'oxyde de silicium (103).

13. Transistor selon la revendication 11 ou 12, comprenant une électrode de contrôle reliée à une portion du support (105) située sous l'ailette (107).
